(19) Europäisches Patentamt
European Patent Office
Office européen des brevets

(11) **EP 2 037 576 B1**

(12) **FASCICULE DE BREVET EUROPEEN**

(45) Date de publication et mention
de la délivrance du brevet:
**20.08.2014 Bulletin 2014/34**

(51) Int Cl.:
*H04B 1/04* *(2006.01)* *H03H 7/40* *(2006.01)*
*H03F 3/24* *(2006.01)* *H03F 1/56* *(2006.01)*

(21) Numéro de dépôt: **08164092.2**

(22) Date de dépôt: **10.09.2008**

(54) **Procédé d'adaptation automatique d'impedance de circuit radiofréquence et chaîne d'emission ou réception à adaptation automatique**

Verfahren zur automatischen Impedanzanpassung einer Radiofrequenzschaltung und einer Funksender- oder -empfangskette mit automatischer Anpassung

Method of automatically adapting the impedance of a radiofrequency circuit and emission or reception instrumentation with automatic adaptation

(84) Etats contractants désignés:
**DE FR GB IT**

(30) Priorité: **11.09.2007 FR 0706360**

(43) Date de publication de la demande:
**18.03.2009 Bulletin 2009/12**

(73) Titulaire: **Commissariat à l'Énergie Atomique et aux Énergies Alternatives
75015 Paris (FR)**

(72) Inventeurs:
• **Chan Wai Po, Francis
38100 GRENOBLE (FR)**
• **De Foucauld, Emeric
38170 SEYSSINET (FR)**

• **Vincent, Pierre
38250 VILLARD DE LANS (FR)**

(74) Mandataire: **Guérin, Michel et al
Marks & Clerk France
Conseils en Propriété Industrielle
Immeuble Visium
22, Avenue Aristide Briand
94117 Arcueil Cedex (FR)**

(56) Documents cités:
**EP-A1- 1 800 410      DE-A1- 1 915 760
DE-B- 1 221 348      DE-B1- 1 766 154
FR-A- 2 573 940      FR-A- 2 715 869
US-A1- 2007 035 356      US-B1- 6 259 334**

**Description**

L'invention concerne la réalisation d'un circuit d'adaptation automatique d'impédance d'antenne radio.

Dans certaines applications de transmission d'informations en radiofréquence, on a constaté que l'antenne d'émission ou de réception pouvait avoir une impédance dépendant fortementde conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

Une chaîne d'émission (respectivement de réception) comprend au moins un amplificateur auquel peuvent être associés un ou plusieurs filtres.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi on a déjà essayé d'interposer entre la sortie de la chaîne d'émission et l'antenne d'émission (et on pourrait le faire aussi en entrée pour une antenne de réception) un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances.

Dans la technique antérieure illustrée par le brevet US 4 375 051, on a proposé d'utiliser un coupleur bidirectionnel pour détecter une désadaptation : la puissance de l'amplificateur est appliquée à une charge par l'intermédiaire du coupleur et d'un réseau d'adaptation d'impédance ; si l'ensemble est désadapté, une partie de la puissance envoyée à l'antenne est réfléchie par celle-ci au lieu d'être envoyée dans le milieu environnant ; la partie réfléchie repasse dans le coupleur et en sort par une sortie spécifique ; la puissance de sortie réfléchie est détectée, mesurée, et sert à asservir le réseau d'impédance pour modifier sa constitution dans un sens tendant à réduire la puissance réfléchie. Le réseau d'adaptation comprend des condensateurs variables.

Ce procédé souffre de deux inconvénients : d'une part la puissance réfléchie peut être faible et sujette à des interférences parasites car toute interférence captée par l'antenne vient fausser la mesure du fait qu'elle s'additionne à la puissance réfléchie alors qu'elle ne constitue pas une puissance réfléchie par la désadaptation. D'autre part il n'y a pas de relation biunivoque entre la quantité de puissance réfléchie (qui sert d'entrée à l'asservissement) et la valeur complexe d'impédance qu'il faudrait donner au réseau d'adaptation pour adapter vraiment l'amplificateur à l'antenne. Ce procédé conduit donc à une nouvelle impédance qui n'est pas nécessairement optimale, car à une puissance donnée correspondent plusieurs couples d'impédance complexes. En effet, la détection de la désadaptation via la mesure de puissance (procédé scalaire) fait perdre l'information du déphasage des courants et tensions. Le procédé connu met donc en oeuvre un système d'asservissement lent, fonctionnant par itérations successives et tâtonnements, sans converger facilement vers une position d'adaptation stable. Enfin, les coupleurs bidirectionnels qu'il utilise sont encombrants. Ces systèmes ne conviennent pas bien pour des applications où la rapidité d'adaptation et l'encombrement sont des critères importants. Le brevet US 6 259 334 concerne des procédés et des dispositifs pour le réglage d'un réseau d'adaptation d'impédance pour minimiser la puissance réfléchie entre un générateur de haute fréquence et une charge. Le réseau d'adaptation d'impédance comporte un ensemble d'éléments à impédance variable. L'un des procédés comprend la mesure du vecteur d'impédance aux bornes du réseau d'adaptation d'impédance en prenant en compte aussi l'impédance de la charge. Le procédé comprend en outre la détermination des directions et des vitesses relatives de variation pour les valeurs d'éléments d'impédance variable, qui sont calculés à une pluralité de valeurs voisines des valeurs actuelles des éléments à impédance variable, en réponse à une impédance de la charge. Finalement, l'ensemble de valeurs voisines ayant la plus faible puissance réfléchie parmi la pluralité de valeurs voisines est choisi.

Selon l'invention, on propose de détecter à la fois l'amplitude et la phase du courant et de la tension en sortie de la chaîne d'émission (ou en entrée de la chaîne de réception). La détection de la désadaptation est donc vectorielle et le rapport entre la tension et le courant est véritablement représentatif de l'impédance Z vue par la chaîne chargé par l'ensemble du réseau d'adaptation et de l'antenne d'impédance $Z_{ant}$, à la condition qu'on considère les tensions et courants sous forme vectorielle, c'est-à-dire en tenant compte du déphasage entre courant et tension. L'impédance de charge vue par l'amplificateur est une fonction de l'impédance d'antenne $Z_{ant}$ et des diverses impédances du réseau d'adaptation ; on calcule alors l'impédance d'antenne $Z_{ant}$ à partir de l'impédance de charge mesurée Zm et des impédances du réseau d'adaptation dont la configuration est connue au moment de la mesure, et enfin on calcule la modification qu'il faut appliquer à une ou plusieurs des impédances du réseau d'adaptation, pour obtenir que l'impédance vue par l'amplificateur devienne adaptée à l'impédance nominale de l'amplificateur dans les conditions actuelles d'environnement de l'antenne.

L'invention permet donc de calculer directement le réseau d'adaptation optimum d'impédance d'une façon mathématique, donc sûre et rapide.

Ainsi, l'invention propose plus précisément un procédé d'adaptation automatique d'impédance pour une chaîne d'émission radiofréquence, suivant la revendication 1.

Et symétriquement, pour un circuit de réception radiofréquence, l'invention propose un procédé d'adaptation automatique d'impédance pour une chaîne de réception radiofréquence, suivant la revendication 2.

Pour un circuit radiofréquence fonctionnant à la fois en émission et en réception avec une seule antenne d'émission-réception et ayant donc un amplificateur d'émission et un amplificateur de réception, on peut prévoir deux réseaux d'adaptation distincts, l'un pour adapter la charge en sortie de l'amplificateur d'émission, l'autre pour adapter la charge en entrée de l'amplificateur de réception.

Une impédance de mesure de valeur complexe connue est insérée en série entre l'amplificateur et le réseau d'adaptation ; elle permet de déterminer le courant qui va servir à calculer l'impédance complexe. Cette impédance de mesure peut être une simple capacité.

De préférence, le procédé comprend l'élaboration d'une tension électrique de commande, fonction du résultat de calcul d'une nouvelle valeur d'impédance ajustable du réseau d'adaptation, et l'application de cette tension à une capacité variable, commandable par une tension électrique, faisant partie du réseau d'adaptation.

Le procédé peut aussi comprendre l'élaboration de signaux de commande de commutation à partir du résultat du calcul d'une nouvelle valeur d'impédance ajustable, et l'application de ces signaux à un réseau de capacités élémentaires commutables, faisant partie du réseau d'adaptation.

L'invention concerne également une chaîne d'émission ou de réception radiofréquence, suivant la revendication 5.

Le réseau d'adaptation peut être constitué d'un montage simple à trois impédances réactives en Té ou en Pi, par exemple une capacité et deux inductances ou mieux une inductance et deux capacités. Au moins une de ces impédances est variable mais en pratique deux des impédances seront variables. De préférence on utilisera deux capacités variables et une inductance fixe en considérant qu'il est plus facile de réaliser des capacités variables précises que des inductances variables. Le réseau d'adaptation peut aussi avoir plusieurs étages en cascade si la désadaptation risque d'être particulièrement forte. Dans ce cas, chaque étage peut être constitué par un montage simple à trois impédances réactives en Té ou en Pi avec en principe deux impédances réactives variables dans chaque étage.

Les impédances variables peuvent être réalisées sous forme de plusieurs impédances élémentaires en série et/ou en parallèle, individuellement commutables par une commande électronique. Une capacité variable peut aussi être réalisée par un élément commandable par une tension électrique.

Le but de l'invention est d'obtenir idéalement une impédance de charge ou d'entrée globale de l'amplificateur égale à l'impédance d'entrée ou de charge nominale de l'amplificateur, mais la précision de réglage des éléments ajustables du réseau d'adaptation n'est pas infinie et on cherchera donc en pratique à s'approcher autant que possible de cette impédance nominale.

D'autres caractéristiques et avantages de l'invention apparaîtront à la lecture de la description détaillée qui suit et qui est faite en référence aux dessins annexés dans lesquels :

- la figure 1 représente la constitution générale d'un circuit d'émission radiofréquence comportant des moyens d'adaptation automatique d'impédance ;
- la figure 2 représente un diagramme de principe des principales étapes du procédé selon l'invention ;
- la figure 3 représente un exemple de réseau d'adaptation d'impédance simple, en Pi, avec deux capacités variables.

Dans la description détaillée qui suit, on considérera systématiquement que l'antenne est une antenne d'émission alimentée par la sortie d'un amplificateur qui est conçu pour fonctionner de manière optimale lorsque la charge placée à sa sortie a une impédance nominale $Z_{opt}$ et lorsque la fréquence de fonctionnement est f, correspondant à une pulsation $\omega = 2\pi.f$. A haute fréquence, l'impédance $Z_{opt}$ sera généralement complexe. Mais l'invention est applicable de la même manière si l'antenne est une antenne de réception connectée à l'entrée d'un amplificateur conçu pour fonctionner de manière optimale lorsque l'impédance connectée à son entrée est une impédance nominale $Z_{opt}$ et lorsque la fré-

quence de fonctionnement est f. Si l'antenne doit fonctionner à la fois en émission et en réception, l'amplificateur d'émission aura de préférence une impédance de charge nominale égale à l'impédance d'entrée nominale de l'amplificateur de réception. Si ce n'est pas le cas, l'amplificateur d'émission et l'amplificateur de réception seront associés à deux réseaux d'adaptation distincts, l'un adaptant la charge de sortie de l'amplificateur d'émission, l'autre adaptant la charge d'entrée de l'amplificateur de réception. La méthode étant la même pour l'émission et la réception et les calculs étant également les mêmes on décrira l'invention seulement à propos de l'amplificateur et l'antenne d'émission.

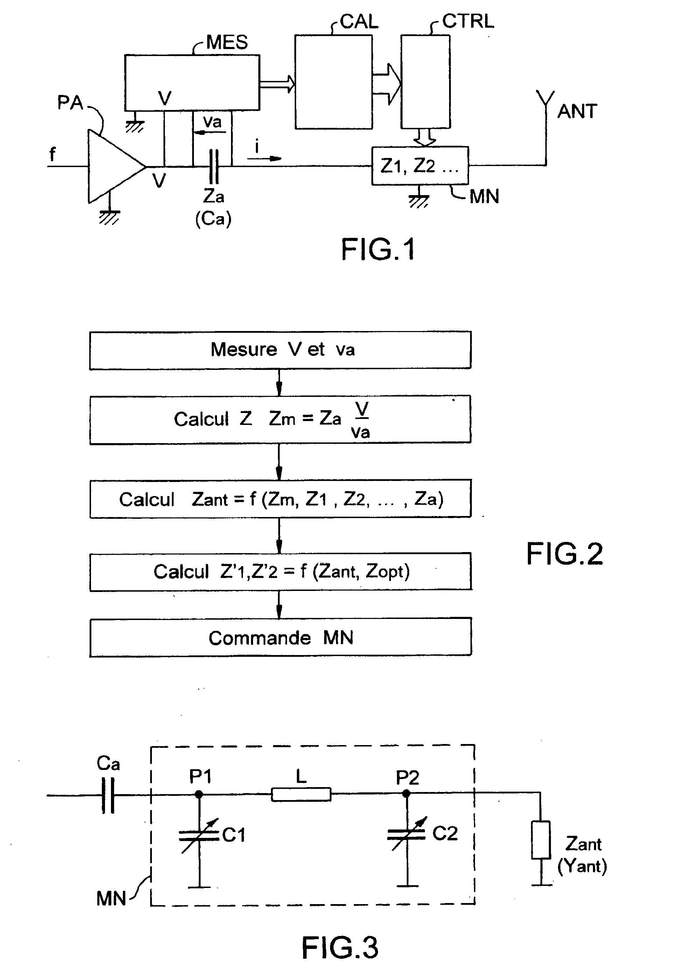

La figure 1 représente le schéma de principe du circuit d'émission radiofréquence selon l'invention, avec un amplificateur PA travaillant à la fréquence porteuse d'émission f, une antenne ANT alimentée par l'amplificateur, un réseau d'adaptation MN inséré en série entre la sortie de l'amplificateur PA et l'antenne ANT. Ce schéma pourrait aussi inclure un filtre entre l'amplificateur PA et le réseau MN et/ou un filtre entre le réseau MN et l'antenne.

On a rajouté selon l'invention, en série entre la sortie de l'amplificateur et le réseau d'adaptation MN une impédance $Z_a$ servant à la mesure du courant i qui sort de l'amplificateur. L'impédance $Z_a$ est de préférence une simple capacité $C_a$ d'impédance $Z_a = 1/j.C_a.\omega$. La tension à ses bornes est une tension va égale à $Z_a.i$, ou encore va = $i/j.C_a.\omega$. Une telle capacité est utilisable quel que soit le domaine de fréquence et quelle que soit la dimension du circuit réalisé. Le fait d'utiliser une telle capacité constitue également une solution moins onéreuse qu'une approche basée sur l'utilisation d'un transformateur.

La tension de sortie de l'amplificateur, qui alimente le réseau MN et l'antenne ANT est une tension V.

L'impédance vue par la sortie de l'amplificateur est donc une impédance Z égale à V/i. Si on mesure V et i en amplitude et en phase, on peut déterminer une valeur actuelle mesurée, Zm, de l'impédance Z vue par l'amplificateur. La valeur Zm est une valeur complexe, avec une partie réelle et une partie imaginaire, à partir du moment où on prend en compte le déphasage entre le courant i et la tension V. Le courant i est déterminé par la mesure de va, connaissant $Z_a$.

Le circuit de la figure 1 comporte donc encore :

- un circuit MES de mesure de la tension Va et de la tension V
- un circuit CAL de calcul pour déterminer en module et en argument et/ou en partie réelle et en partie imaginaire une valeur d'impédance mesurée Zm à partir des mesures de V et va, et pour déterminer ensuite des valeurs d'impédances qu'il faut utiliser dans le réseau d'adaptation MN, en fonction du résultat de la mesure Zm de l'impédance de charge Z, pour rapprocher l'impédance de charge Z de sa valeur nominale $Z_{opt}$ ;
- et un circuit CTRL de commande du réseau d'adaptation MN, qui reçoit les résultats du calcul fait par le circuit CAL pour modifier en conséquence le réseau MN.

Le circuit de mesure MES est essentiellement constitué par un circuit de changement de fréquence classique et un convertisseur analogique-numérique. En effet, les tensions V et va sont des signaux électriques à la fréquence porteuse f. Pour réduire la consommation électrique, et améliorer la précision de calcul, il peut être intéressant d'effectuer le calcul d'impédance à basse fréquence. Il est alors prévu une conversion à une fréquence plus basse pour pouvoir faire les calculs qui suivent. On notera que dans certains cas on peut utiliser, pour constituer ce circuit de mesure, des éléments de circuits présents dans les circuits de réception radiofréquence du système. En effet si le système fonctionne en émission et en réception, la partie réception comporte des circuits de changement de fréquence et ces circuits peuvent très bien servir pour effectuer la mesure de V et va. Dans ce cas la mesure d'impédance est faite dans une phase d'émission de signal par l'amplificateur PA, les circuits de réception étant disponibles à ce moment là.

Le circuit de calcul CAL est un processeur numérique dédié ou un microprocesseur programmé.

Le procédé selon l'invention est résumé dans l'organigramme de la figure 2 et consiste, à l'aide de ces circuits, à calculer le module et l'argument de l'impédance Zm de la charge actuelle de l'amplificateur, calculer à partir de là l'impédance vectorielle Zm en partie réelle et partie imaginaire, calculer l'impédance de l'antenne $Z_{ant}$ à partir de ces valeurs et des valeurs d'impédance actuelles connues des différentes impédances Z1, Z2, etc. qui constituent le réseau d'adaptation MN, calculer une ou plusieurs valeurs d'impédances modifiées Z'1, Z'2 du réseau d'adaptation MN à partir d'une valeur désirée $Z_{opt}$ de l'impédance de charge de l'amplificateur et à partir de l'impédance d'antenne calculée $Z_{ant}$, et commander le réseau MN pour donner aux impédances Z1, Z2 de ce réseau les valeurs modifiées Z'1, Z'2 ainsi calculées.

Par conséquent, on ne réalise pas comme dans l'art antérieur un asservissement tendant à minimiser une puissance réfléchie par l'impédance de charge désadaptée mais on calcule les valeurs théoriques d'impédances du réseau d'adaptation qui optimisent l'impédance de charge dans les conditions actuelles et on les applique à ce réseau.

Le calcul dépend bien entendu de la configuration du réseau d'adaptation MN et on va donner ci-après un exemple pour une configuration de réseau d'adaptation en Pi à trois impédances Z1, Z2, Z3 qui sont constituées par deux capacités variables en dérivation C1 et C2 séparées par une inductance L en série ; ce réseau est représenté à la figure 3. L'impédance $Z_a$ de mesure de courant est, dans cet exemple, une capacité $C_a$ placée en série entre la sortie de l'amplificateur PA et le réseau d'adaptation.

On appellera C1 et C2 les valeurs actuelles des capacités du réseau d'adaptation et C1' et C2' les nouvelles valeurs de ces capacités, calculées selon l'invention pour optimiser l'impédance de charge de l'amplificateur en la rendant autant que possible égale à la valeur optimale Zopt.

Première étape : calcul de l'impédance de charge actuelle

Le circuit de mesure MES reçoit les signaux de tension V et va définis précédemment ; ces tensions sont à la fréquence porteuse f. Elles sont de préférence ramenées à une fréquence intermédiaire ou en bande de base par des circuits de changement de fréquence classiques utilisant un oscillateur local et des mélangeurs. Puis les niveaux de tension V et va ramenés à cette fréquence intermédiaire ou en bande de base sont utilisés pour calculer le courant vectoriel i puis l'impédance complexe V/i vue par l'amplificateur (ou pour calculer directement cette impédance V/i sans passer par la détermination de i). Les déphasages sont conservés dans le changement de fréquence.

Le module de i est le rapport du module de va et du module de l'impédance $Z_a = 1/j.C_a.\omega$ ; ou alternativement le module de l'impédance Z est le module du produit $V.Z_a/V_a$, c'est-à-dire du produit $V/j.C_a.\omega.v_a$. Le déphasage de i par rapport à la tension V est un angle $\theta$ qui représente l'argument de l'impédance Z. Cet angle peut être déterminé à partir du déphasage entre V et va auquel on soustrait $\pi/2$ sachant que le déphasage entre i et $v_a$ est de $\pi/2$ puisque $Z_a$ est une capacité.

Le déphasage entre V et $v_a$ peut être calculé par exemple en multipliant les signaux analogiques V et $v_a$, ramenés en bande de base, et en observant la variation périodique du produit des deux signaux. Ce produit oscille entre une valeur maximum positive et une valeur minimum négative. La somme algébrique de ces deux valeurs est proportionnelle au cosinus du déphasage et le coefficient de proportionnalité est la différence algébrique de ces deux valeurs. Par conséquent, en faisant le rapport entre la somme des deux valeurs et la différence des deux valeurs on trouve le cosinus du déphasage dont on tire le déphasage entre V et $v_a$, d'où on déduit le déphasage entre V et i. D'autres méthodes de calcul numérique du déphasage peuvent être utilisées, par exemple par numérisation des deux signaux V et $v_a$ sur un bit, égal à 1 lorsque le signal est positif et à 0 lorsqu'il est négatif. Le décalage temporel des trains d'impulsions de bits 1 résultant de la numérisation de V, par rapport aux mêmes trains d'impulsions correspondant à la numérisation de $v_a$, représente le déphasage entre V et $v_a$. Le signe du déphasage est repéré en observant les fronts de montée des signaux ainsi numérisés sur un bit ; ceci peut se faire par une bascule D qui reçoit sur une entrée de signal l'une des tensions V ou $v_a$ et sur une entrée d'horloge l'autre de ces tensions, et qui reporte à sa sortie l'état de l'entrée de signal au moment d'un front de montée sur l'entrée d'horloge).

Une fois qu'on a l'argument $\theta$ de l'impédance Z, on peut calculer la partie réelle et la partie imaginaire de Z. On appellera Zm l'impédance ainsi mesurée pour Z ; Zmr est sa partie réelle, Zmi est sa partie imaginaire.

Zmr est égal au module de Z multiplié par $\cos\theta$.

Zmi est égal au module de Z multiplié par $\sin\theta$.

Deuxième étape : calcul de l'impédance actuelle de l'antenne

A partir de cette mesure de Z, connaissant la configuration du réseau d'adaptation qui est celle de la figure 3, avec les valeurs numériques actuelles connues des capacités C1 et C2 et de l'inductance L, et également la valeur numérique de la capacité $C_a$, on peut calculer l'impédance de l'antenne. Les valeurs connues de C1, C2 résultent soit de valeurs initiales des capacités, soit d'une adaptation faite précédemment. Les valeurs de L et $C_a$ sont également communes et sont fixes.

On n'exposera pas tout le détail du calcul mais seulement les étapes principales.

Si on écrit l'impédance $Z_{ant}$ de l'antenne sous la forme

$Z_{ant} = (A+jB)/(C+jD)$, on peut montrer que dans le schéma de la figure 3 :

$$A = 1 - LC1\omega^2 - LC_a\omega^2 - Zmi.LC1C_a\omega^3 + Zmi.C_a\omega.$$

$$B = Zmr.LC1C_a\omega^3 - Zmr.C3\omega.$$

$$C = Zmr.LC1C2C_a\omega^4 - Zmr.C1C_a\omega^2 - Zmr.C2C_a\omega^4.$$

$$D = Zmi.(LC1C2C_a\omega^4 - C1C_a\omega^2 - C2C_a\omega^2) + L\omega^3 (C1C2+C2C_a) - C1\omega - C2\omega - C_a\omega.$$

On en déduit le module et l'argument de l'impédance d'antenne actuelle $Z_{ant}$ :

le module de $Z_{ant}$ est la racine carrée de $(A^2+B^2)/(C^2+D^2)$.
l'argument de $Z_{ant}$ est la différence entre l'arctangente de B/A et l'arctangente de D/C.

La partie réelle de $Z_{ant}$ est ZantR, égale au module multiplié par le sinus de cet argument ; la partie imaginaire de $Z_{ant}$ est Zantim et est le module multiplié par le cosinus de ce même argument.
On peut aussi calculer de la même manière l'admittance $Y_{ant}$ de l'antenne, en partie réelle YantR et en partie imaginaire Yantim.
$Z_{ant}$ et $Y_{ant}$ sont entièrement déterminables après le calcul de Zm.

*Troisième étape : calcul de valeurs modifiées pour le réseau MN*

Connaissant à la fois l'impédance actuelle de l'antenne et toutes les impédances du réseau d'adaptation (C1, C2, L) ainsi que la capacité $C_a$, on peut calculer maintenant les valeurs C'1, C'2, qu'il faut donner aux capacités C1 et C2 pour que l'impédance de l'ensemble, telle qu'elle sera vue aux bornes de l'amplificateur soit égale à la valeur nominale $Z_{opt}$ et non plus à la valeur Zm qu'on a déterminé précédemment. L'égalité parfaite n'étant pas possible, on cherchera à s'en approcher autant que possible, en tenant compte notamment du fait que la précision d'ajustement des capacités du réseau d'adaptation est limitée.
La méthode s'inspire des principes utilisés pour calculer des impédances par les abaques de Smith : on recherche quelles sont les valeurs d'impédance capacitives ou inductives mises en shunt ou en série qui déplacent l'impédance de charge sur l'abaque jusqu'à l'amener au centre de l'abaque, le centre représentant une impédance nominale. Les graduations de ces abaques étant normalisées, avec une impédance nominale unitaire au centre de l'abaque, on considère à chaque fois non pas les valeurs réelles de condensateur ou d'inductances mais leur valeur normalisée, c'est-à-dire divisée par $Z_{opt}$.
Pour simplifier l'écriture des calculs, et par analogie avec l'utilisation d'abaques de Smith, on considérera que les valeurs C1, C2, $C_a$, L, $Z_{ant}$ sont normalisées ; dans la pratique, il faudrait bien entendu commencer par diviser toutes les valeurs par $Z_{opt}$, puis faire les calculs qui suivent pour trouver des valeurs nouvelles pour C1 et C2, et on multiplierait par $Z_{opt}$ les valeurs ainsi trouvées pour déterminer les valeurs réelles qu'il faut donner aux capacités.
Le calcul à partir des valeurs normalisées se déroule en plusieurs phases.
Phase 1 : on part de l'impédance de l'antenne $Z_{ant}$ et on considère qu'il y a une capacité C'2 en dérivation en amont de l'antenne ; on en déduit que l'admittance Y(P2) vue en sortie de l'inductance L (point P2 sur la figure 3) a une partie réelle YR(P2) égale à la partie réelle de l'admittance de l'antenne.

$$Yr(P2) = YantR$$

et elle a une partie imaginaire Yim(P2) au point P2 qui est la somme de la partie imaginaire de l'admittance de l'antenne et de l'admittance de la capacité C'2.

$$Yim(P2) = Yantim + jC'2\omega.$$

$$Y(P2) = YantR +j.(Yantim + jC'2w).$$

On ne connait pas l'admittance de C'2 puisqu'on la cherche.
Mais on sait que l'impédance Z(P1) vue du point P1 en amont du réseau MN et en aval de la capacité C3 à une partie réelle Zr(P1) égale à 1 (c'est la valeur nominale normalisée qu'on veut et la capacité C3 en série ne change pas cette valeur) :

$$Zr(P1) = 1$$

Et on sait que l'impédance Z(P1) vue du point P1 a une partie imaginaire Zim(P1) qui est la différence entre une première valeur qui est la valeur (en principe 0) de la partie imaginaire de l'impédance de charge totale normalisée désirée pour l'amplificateur et une deuxième valeur qui est l'impédance série de la capacité $C_a$, soit $1/jC_{a\omega}$.

$$Zim(P1) = -1/jC_a\omega.$$

La partie réelle et la partie imaginaire de l'impédance Z(P1) désirée au point P1 sont donc parfaitement déterminables à partir de $C_a$.

Connaissant maintenant l'impédance désirée vue vers l'aval depuis P1, on en déduit l'admittance désirée vue vers l'aval depuis P1, à savoir l'inverse de l'impédance.

L'admittance désirée vue de P1 est Y(P1), avec une partie réelle YR(P1) et une partie imaginaire Yim(P1) qui sont également complètement calculables.

Enfin, on sait qu'en plaçant la capacité C'1 en dérivation au point P1, l'admittance vue vers l'aval (vers l'antenne) du point P1 sera la somme de l'admittance de la capacité C'1 et de l'admittance YS d'un ensemble en série de l'inductance L et de l'admittance Y(P2) mentionnée plus haut.

L'ensemble en série a une impédance ZS qui est la somme de l'impédance $jL\omega$ de l'inductance et de l'inverse de l'admittance Y(P2).

$$ZS = jL\omega + 1/Y(P2)$$

Soit

$$ZS = jL\omega + 1/[YantR + j.(Yantim + jC'2w)]$$

Et l'admittance YS de ce même ensemble est l'inverse de l'impédance donc

$$YS = 1/ZS = 1/\{jL\omega + 1/[YantR + j.(Yantim + jC'2w)]\}$$

L'admittance vue du point P1 est la somme de l'admittance YS et de l'admittance de la capacité C'1 (dont la valeur est inconnue).

$$Y(P1) = YS + jC'1\omega$$

On rappelle que Y(P1) est connu par les calculs indiqués plus haut avec sa partie réelle YR(P1) et sa partie imaginaire Yim(P1).

On a donc l'égalité

$$1/\{jL\omega + 1/[YantR + j.(Yantim + jC'2w)]\} + jC'1\omega = YR(P1) + Yim(P1)$$

Si on développe cette égalité pour faire apparaître les parties réelle et imaginaire du membre de gauche, il ne reste plus qu'à égaliser la partie réelle du membre de gauche avec la partie réelle du membre de droite et la partie imaginaire du membre de gauche avec la partie imaginaire du membre de droite.

On aboutit à un système de deux équations à deux inconnues C'1 et C'2, qui peut être facilement résolu par calcul, avec en pratique une seule solution viable.

On calcule donc C'1 et C'2 qui sont les nouvelles valeurs à donner aux capacités C1 et C2 du réseau d'adaptation MN pour avoir une adaptation parfaite.

On rappelle à ce stade que les valeurs calculées C'1 et C'2 sont normalisées pour une impédance nominale normalisée unitaire et que si l'impédance nominale souhaitée est $Z_{opt}$ différent de 1, il faut bien sûr multiplier les résultats par $Z_{opt}$ pour trouver les valeurs réelles nécessaires pour C'1 et C'2.

Dans les calculs qui précèdent, on a considéré qu'on mesurait la tension de sortie V immédiatement en sortie de l'amplificateur de mesure, pour obtenir l'impédance de charge Z=V/i dans le but de trouver les valeurs qui rendent cette impédance égale à l'impédance optimale. On comprendra qu'on aurait aussi pu mesurer une tension de sortie d'amplificateur V' en aval de l'impédance de mesure $Z_a$ ($C_a$) pour déterminer une impédance mesurée Z' = V'/i et calculer l'impédance d'antenne $Z_{ant}$ non pas en fonction de Z mais en fonction de Z' en considérant que Z est tout simplement égal à Z'+$Z_a$. Les calculs à partir de Z' se déduisent donc immédiatement des calculs à partir de Z. L'impédance qui doit être rendue aussi proche que possible de $Z_{opt}$ est bien entendu l'impédance Z'+$Z_a$.

On comprend que des calculs similaires peuvent être faits sur le même principe avec un réseau d'adaptation qui serait différent du réseau C1, C2, L de la figure 2, et également avec une impédance de mesure de courant qui serait différente de la capacité $C_a$.

A partir de là, les circuits de calcul (en pratique constitués par un microprocesseur programmé) fournissent des signaux de commande à un circuit de commande (CTRL sur la figure 1) qui va donner aux capacités C1 et C2 les nouvelles valeurs désirées C'1 et C'2.

Chaque capacité peut être organisée en réseau de capacités en série et/ou en parallèle, commutables individuellement par des commutateurs. Le circuit de commande CTRL est alors constitué par ces commutateurs qui ajustent la capacité globale en plaçant le nombre d'éléments qui convient en série et/ou en parallèle. Les commutateurs sont commandés par le microprocesseur.

On peut aussi envisager que la capacité C1 ou la capacité C2 soit une capacité variable commandable par une tension (une diode varactor par exemple) et dans ce cas la donnée numérique définissant la capacité C'1 ou C'2 est fournie par le microprocesseur et le circuit de commande comprend alors un convertisseur numérique analogique qui convertit cette donnée en une tension appropriée de commande de la capacité variable pour que celle-ci prenne la valeur désirée.

L'adaptation d'impédance peut être effectuée soit une seule fois pour une calibration du système, soit plusieurs fois, par exemple à chaque fois qu'une émission de signal est effectuée à partir de l'amplificateur, soit enfin en permanence : le calcul est renouvelé systématiquement pour vérifier l'adaptation et pour la corriger si nécessaire. Cette dernière solution est avantageuse puisqu'elle permet une adaptation à n'importe quel changement, mais elle a l'inconvénient de consommer plus d'énergie.

Si l'adaptation n'est pas recalculée en permanence, on peut utiliser certains éléments du récepteur, et notamment les circuits de transposition de fréquence, pour effectuer la conversion en fréquence intermédiaire nécessaire à la mesure des tensions V et $v_a$.

Si on résume les avantages de l'invention, on peut dire que :

- on dispose d'une adaptation automatique d'impédance rapide ; il n'y a pas d'itérations successives mais une seule opération de calcul global ; la durée peut donc être réduite d'un facteur 100 par rapport à l'art antérieur ;
- l'adaptation est précise et les pertes de désadaptation peuvent donc être minimisées, d'où une amélioration de la performance globale de l'émetteur ou du récepteur, que ce soit en portée, en sensibilité, en rapport signal/bruit ;
- des modules du récepteur peuvent être utilisés pour l'opération d'adaptation si celle-ci se fait en phase d'émission de signal dans un émetteur-récepteur ;
- l'intégration est optimisée en encombrement du fait qu'il n'est pas nécessaire de prévoir un coupleur bidirectionnel ;
- avec un circuit de mesure mettant en oeuvre une transposition de fréquence, les filtres à fréquence intermédiaire contribuent à minimiser l'influence des interférences parasites pouvant se superposer aux tensions de mesure V et $v_a$.

Cette invention pourra avantageusement être mise en oeuvre dans des applications embarquées, les calculs pouvant être réalisés par des microprocesseurs.

**Revendications**

1. Procédé d'adaptation automatique d'impédance pour une chaîne d'émission radiofréquence comprenant au moins un amplificateur (PA), une antenne (ANT), et un réseau d'adaptation d'impédance (MN) entre l'amplificateur et l'antenne, ce réseau comprenant plusieurs impédances dont certaines ont des valeurs numériques ajustables, la chaîne d'émission ayant des performances désirées lorsqu'une impédance de charge nominale est connectée à la sortie de l'amplificateur (PA), le procédé comprenant les étapes suivantes :

- détermination de la tension de sortie de l'amplificateur (v) et détermination du courant de sortie de l'amplificateur (i) à partir d'une capacité de mesure (Ca) insérée en série entre la sortie de l'amplificateur et le réseau d'adaptation,
- calcul de l'impédance complexe définie par le rapport entre cette tension (v) et ce courant (i) en tenant compte de leur déphasage, cette impédance représentant une impédance de charge actuelle de l'amplificateur,
- calcul de l'impédance de l'antenne en fonction de cette impédance de charge actuelle et en fonction des valeurs actuelles connues des impédances ajustables du réseau d'adaptation,
- calcul de nouvelles valeurs d'impédances ajustables du réseau d'adaptation à partir d'une valeur désirée de l'impédance de charge de l'amplificateur et de l'impédance d'antenne calculée, les dites nouvelles valeurs permettant d'obtenir une impédance de charge globale de l'amplificateur aussi proche que possible de l'impédance de charge nominale,
- commande (CTRL) du réseau d'adaptation pour ajuster les impédances ajustables à ces nouvelles valeurs.

2. Procédé d'adaptation automatique d'impédance pour une chaîne de réception radiofréquence comprenant au moins une antenne (ANT), un amplificateur (PA) et un réseau d'adaptation d'impédance (MN) entre l'antenne et l'amplificateur, ce réseau comprenant plusieurs impédances dont certaines ont des valeurs numériques ajustables, la chaîne de réception ayant des performances désirées lorsqu'une impédance d'entrée nominale est connectée à l'entrée de l'amplificateur, ce procédé comprenant les étapes suivantes :

- détermination de la tension d'entrée de l'amplificateur, et détermination du courant d'entrée de l'amplificateur à partir d'une capacité de mesure insérée en série entre l'entrée de l'amplificateur et le réseau d'adaptation,
- calcul de l'impédance complexe définie par le rapport entre cette tension et ce courant en tenant compte de leur déphasage, cette impédance représentant une impédance d'entrée actuellement connectée à l'amplificateur,
- calcul de l'impédance de l'antenne en fonction de cette impédance d'entrée actuelle et en fonction des valeurs actuelles connues des impédances ajustables du réseau d'adaptation,
- calcul de nouvelles valeurs d'impédances ajustables du réseau d'adaptation à partir d'une valeur désirée de l'impédance d'entrée de l'amplificateur et de l'impédance de l'antenne calculée, les dites nouvelles valeurs permettant d'obtenir une impédance d'entrée globale de l'amplificateur aussi proche que possible de l'impédance d'entrée nominale,
- commande du réseau d'adaptation pour ajuster les impédances ajustables à ces nouvelles valeurs.

3. Procédé d'adaptation automatique d'impédance selon l'une des revendications 1 et 2, **caractérisé en ce qu'**il comprend l'élaboration d'une tension électrique de commande, fonction d'une nouvelle valeur d'impédance ajustable du réseau d'adaptation, et l'application de cette tension à une capacité variable, commandable par une tension électrique, faisant partie du réseau d'adaptation.

4. Procédé d'adaptation automatique d'impédance selon l'une des revendications 1 à 3, **caractérisé en ce qu'**il comprend l'élaboration de signaux de commande de commutation à partir du résultat du calcul d'une nouvelle valeur d'impédance ajustable, et l'application de ces signaux à un réseau de capacités élémentaires commutables, faisant partie du réseau d'adaptation.

5. Chaîne d'émission ou de réception radiofréquence comportant au moins un amplificateur (PA) ayant une impédance de charge ou d'entrée nominale, une antenne (ANT), et un réseau d'adaptation d'impédance (MN) entre l'amplificateur et l'antenne, ce réseau comprenant plusieurs impédances dont certaines ont des valeurs numériques ajustables, la chaîne comportant :

- une capacité de mesure ($C_a$) de valeur complexe connue insérée en série entre l'amplificateur et le réseau d'adaptation,
- des moyens de mesure (MES) d'une première tension qui est la tension aux bornes de l'impédance de mesure et d'une deuxième tension qui est la tension en sortie de l'amplificateur pour une chaîne d'émission ou la tension en entrée de l'amplificateur pour une chaîne de réception,
- des moyens de calcul (CAL) de l'impédance complexe définie par le rapport entre la deuxième tension et la première tension, en tenant compte du déphasage entre ces tensions, cette impédance complexe représentant une impédance de charge ou d'entrée actuelle de l'amplificateur,
- des moyens de calcul (CAL) de l'impédance de l'antenne en fonction de cette impédance de charge ou d'entrée actuelle et en fonction des valeurs actuelles connues des impédances ajustables du réseau d'adaptation,
- des moyens de calcul de nouvelles valeurs d'impédance ajustables du réseau d'adaptation à partir d'une valeur désirée de l'impédance de charge ou d'entrée de l'amplificateur et de l'impédance d'antenne calculée, les dites nouvelles valeurs permettant d'obtenir une impédance de charge ou d'entrée globale de l'amplificateur aussi proche que possible de l'impédance de charge ou d'entrée nominale,

- des moyens de commande électrique (CTRL) du réseau d'adaptation pour ajuster les impédances ajustables à ces nouvelles valeurs.

6. Chaîne d'émission ou réception radiofréquence selon la revendication 5, **caractérisée en ce que** le réseau d'adaptation comprend un montage en Té ou en Pi de trois éléments réactifs (L, C1, C2).

7. Chaîne d'émission ou réception radiofréquence selon la revendication 6, **caractérisée en ce que** le montage en Té ou en Pi comprend deux capacités (C1, C2) et une inductance (L) ou deux inductances et une capacité.

8. Chaîne d'émission ou réception radiofréquence selon la revendication 7, **caractérisée en ce que** le réseau d'adaptation comprend deux capacités ajustables (C1, C2).

9. Chaîne d'émission ou réception radiofréquence selon la revendication 8, **caractérisée en ce que** le réseau d'adaptation comprend un montage en Pi avec deux capacités ajustables (C1, C2) en dérivation et une inductance (L) en série entre les bornes des deux capacités.

10. Chaîne d'émission ou réception radiofréquence selon l'une des revendications 5 à 9, **caractérisée en ce que** le réseau d'adaptation comprend au moins une capacité variable constituée par un réseau de capacités élémentaires commutables de manière à établir à volonté des valeurs de capacités sélectivement ajustables par une commande électrique.

11. Chaîne d'émission ou réception radiofréquence selon l'une des revendications 5 à 9, **caractérisé en ce que** le réseau d'adaptation comprend au moins une capacité variable commandable par une tension électrique.

## Patentansprüche

1. Verfahren zur automatischen Impedanzanpassung für eine Funkfrequenzsendekette, die wenigstens einen Verstärker (PA), eine Antenne (ANT) und ein Impedanzanpassungsnetz (MN) zwischen dem Verstärker und der Antenne umfasst, wobei dieses Netz mehrere Impedanzen umfasst, von denen bestimmte justierbare digitale Werte haben, wobei die Sendekette gewünschte Leistungen hat, wenn eine Nennladungsimpedanz mit dem Ausgang des Verstärkers (PA) verbunden ist, wobei das Verfahren die folgenden Schritte beinhaltet:

- Ermitteln der Ausgangsspannung (v) des Verstärkers und Ermitteln des Ausgangsstroms (i) des Verstärkers anhand einer Messkapazität (Ca), die in Serie zwischen dem Ausgang des Verstärkers und dem Anpassungsnetz geschaltet ist,
- Berechnen der komplexen Impedanz, die durch das Verhältnis zwischen dieser Spannung (v) und diesem Strom (i) unter Berücksichtigung ihrer Phasenverschiebung definiert wird, wobei diese Impedanz eine Ist-Ladungsimpedanz des Verstärkers repräsentiert,
- Berechnen der Impedanz der Antenne in Abhängigkeit von dieser Ist-Ladungsimpedanz und in Abhängigkeit von bekannten Istwerten der justierbaren Impedanzen des Anpassungsnetzes,
- Berechnen neuer justierbarer Impedanzwerte des Anpassungsnetzes auf der Basis eines gewünschten Wertes der Ladungsimpedanz des Verstärkers und der berechneten Antennenimpedanz, wobei mit den neuen Werten eine globale Ladungsimpedanz des Verstärkers möglichst nahe an der Nennladungsimpedanz erhalten werden kann,
- Steuern (CTRL) des Anpassungsnetzes zum Justieren der justierbaren Impedanzen auf diese neuen Werte.

2. Verfahren zur automatischen Impedanzanpassung für eine Funkfrequenzempfangskette, die wenigstens eine Antenne (ANT), einen Verstärker (PA) und ein Impedanzanpassungsnetz (MN) zwischen der Antenne und dem Verstärker umfasst, wobei dieses Netz mehrere Impedanzen umfasst, von denen bestimmte justierbare digitale Werte haben, wobei die Empfangskette gewünschte Leistungen hat, wenn eine Nenneingangsimpedanz mit dem Eingang des Verstärkers verbunden ist, wobei das Verfahren die folgenden Schritte beinhaltet:

- Ermitteln der Eingangsspannung des Verstärkers und Ermitteln des Eingangsstroms des Verstärkers anhand einer Messkapazität, die in Serie zwischen dem Eingang des Verstärkers und dem Anpassungsnetz geschaltet ist,

- Berechnen der komplexen Impedanz, die durch das Verhältnis zwischen dieser Spannung und diesem Strom unter Berücksichtigung ihrer Phasenverschiebung definiert wird, wobei diese Impedanz eine mit dem Verstärker aktuell gekoppelte Eingangsimpedanz repräsentiert,
- Berechnen der Impedanz der Antenne in Abhängigkeit von dieser Ist-Eingangsimpedanz und in Abhängigkeit von bekannten Istwerten von justierbaren Impedanzen des Anpassungsnetzes,
- Berechnen neuer justierbarer Impedanzwerte des Anpassungsnetzes auf der Basis eines gewünschten Wertes der Eingangsimpedanz des Verstärkers und der berechneten Impedanz der Antenne, wobei mit den neuen Werten eine globale Eingangsimpedanz des Verstärkers möglichst nahe an der Nenneingangsimpedanz erhalten werden kann,
- Steuern des Anpassungsnetzes zum Justieren der justierbaren Impedanzen auf diese neuen Werte.

3.  Verfahren zur automatischen Impedanzanpassung nach einem der Ansprüche 1 und 2, **dadurch gekennzeichnet, dass** es das Ausarbeiten einer elektrischen Steuerspannung in Abhängigkeit von einem neuen justierbaren Impedanzwert des Anpassungsnetzes und das Anlegen dieser Spannung an eine variable Kapazität beinhaltet, die durch eine elektrische Spannung gesteuert werden kann, die Teil des Anpassungsnetzes ist.

4.  Verfahren zur automatischen Impedanzanpassung nach einem der Ansprüche 1 bis 3, **dadurch gekennzeichnet, dass** es das Ausarbeiten von Umschaltsteuersignalen auf der Basis des Ergebnisses der Berechnung eines neuen justierbaren Impedanzwertes und das Anlegen dieser Signale an ein Netz von umschaltbaren Elementarkapazitäten beinhaltet, die Teil des Anpassungsnetzes sind.

5.  Funkfrequenzsende- oder -empfangskette, die wenigstens einen Verstärker (PA) mit einer Nennladungs- oder Nenneingangsimpedanz, eine Antenne (ANT) und ein Impedanzanpassungsnetz (MN) zwischen dem Verstärker und der Antenne umfasst, wobei dieses Netz mehrere Impedanzen umfasst, von denen bestimmte justierbare digitale Werte haben, wobei die Kette Folgendes umfasst:

    - eine Messkapazität (Ca) mit einem komplexen bekannten Wert, der in Serie zwischen dem Verstärker und dem Anpassungsnetz geschaltet ist,
    - Mittel (MES) zum Messen einer ersten Spannung, die die Spannung an den Anschlüssen der Messimpedanz ist, und einer zweiten Spannung, die die Spannung am Ausgang des Verstärkers für eine Sendekette oder die Spannung am Eingang des Verstärkers für eine Empfangskette ist,
    - Mittel (CAL) zum Berechnen der komplexen Impedanz, die durch das Verhältnis zwischen der zweiten Spannung und der ersten Spannung definiert wird, unter Berücksichtigung der Phasenverschiebung zwischen diesen Spannungen, wobei diese komplexe Impedanz eine Ist-Ladungs- oder Ist-Eingangsimpedanz des Verstärkers repräsentiert,
    - Mittel (CAL) zum Berechnen der Impedanz der Antenne in Abhängigkeit von dieser Ist-Ladungs- oder Ist-Eingangsimpedanz und in Abhängigkeit von bekannten Istwerten der justierbaren Impedanzen des Anpassungsnetzes,
    - Mittel zum Berechnen neuer justierbarer Impedanzwerte des Anpassungsnetzes anhand eines gewünschten Wertes der Ladungs- oder Eingangsimpedanz des Verstärkers und der berechneten Antennenimpedanz, wobei mit diesen neuen Werten eine globale Ladungs- oder Eingangsimpedanz des Verstärkers möglichst nahe an der Nennladungs- oder Nenneingangsimpedanz erhalten werden kann,
    - Mittel (CTRL) zum elektrischen Steuern des Anpassungsnetzes zum Justieren der justierbaren Impedanzen auf diese neuen Werte.

6.  Funkfrequenzsende- oder -empfangskette nach Anspruch 5, **dadurch gekennzeichnet, dass** das Anpassungsnetz ein T- oder Pi-Montagestück aus drei reaktiven Elementen (L, C1, C2) umfasst.

7.  Funkfrequenzsende- oder -empfangskette nach Anspruch 6, **dadurch gekennzeichnet, dass** das T- oder Pi-Montagestück zwei Kapazitäten (C1, C2) und eine Induktanz (L) oder zwei Induktanzen und eine Kapazität umfasst.

8.  Funkfrequenzsende- oder -empfangskette nach Anspruch 7, **dadurch gekennzeichnet, dass** das Anpassungsnetz zwei justierbare Kapazitäten (C1, C2) umfasst.

9.  Funkfrequenzsende- oder -empfangskette nach Anspruch 8, **dadurch gekennzeichnet, dass** das Anpassungsnetz ein Pi-Montagestück mit zwei verzweigten justierbaren Kapazitäten (C1, C2) und einer Induktanz (L) in Serie zwischen den Anschlüssen der beiden Kapazitäten umfasst.

10. Funkfrequenzsende- oder -empfangskette nach einem der Ansprüche 5 bis 9, **dadurch gekennzeichnet, dass** das Anpassungsnetz wenigstens eine variable Kapazität umfasst, die durch ein elementares umschaltbares Kapazitätsnetz gebildet wird, um nach Belieben durch einen elektrischen Befehl selektiv justierbare Kapazitätswerte einzustellen.

11. Funkfrequenzsende- oder -empfangskette nach einem der Ansprüche 5 bis 9, **dadurch gekennzeichnet, dass** das Anpassungsnetz wenigstens eine durch eine elektrische Spannung steuerbare variable Kapazität umfasst.

**Claims**

1. Automatic impedance matching method for a radiofrequency transmission system comprising at least an amplifier (PA), an antenna (ANT), and an impedance matching network (MN) between the amplifier and the antenna, this network comprising several impedances, some of which have adjustable numerical values, the transmission system having desired performance capabilities when a nominal load impedance is connected to the output of the amplifier (PA), the method comprising the following steps:

   - determination of the output voltage (v) of the amplifier and determination of the output current (i) of the amplifier from a measurement capacitance ($C_a$)inserted in series between the output of the amplifier and the matching network ;
   - calculation of the complex impedance defined by the relationship between this voltage (v) and this current (i), taking account of their phase shift, this impedance representing a present load impedance of the amplifier;
   - calculation of the antenna impedance as a function of this present load impedance and as a function of the known present values of the adjustable impedances of the matching network;
   - calculation, from a desired value of the load impedance of the amplifier and from the calculated value of the antenna impedance, of new values for the adjustable impedances of the matching network, said new values allowing an overall load impedance of the amplifier to be obtained which is as close as possible to the nominal load impedance; and
   - control (CTRL)of the matching network to adjust the adjustable impedances to these new values.

2. Automatic impedance matching method for a radiofrequency reception system comprising at least an antenna, an amplifier, and an impedance matching network between the antenna and the amplifier, this network comprising several impedances, some of which have adjustable numerical values, the reception system having the desired performance when a nominal input impedance is connected to the input input of the amplifier, this method being **characterized in that** it comprises the following steps:

   - determination of the input voltage of the amplifier and determination of the input current of the amplifier from a measurement capacitance inserted in series between the input of the amplifier and the matching network;
   - calculation of the complex impedance defined by the relationship between this voltage and this current, taking account of their phase shift, this impedance representing an input impedance presently connected to the amplifier;
   - calculation of the antenna impedance as a function of this present input impedance and as a function of the known present values of the adjustable impedances of the matching network;
   - calculation, from a desired value of the input impedance of the amplifier and from the calculated value of the antenna impedance, of new values for the adjustable impedances of the matching network, said new values allowing an overall input impedance of the amplifier to be obtained which is as close as possible to the nominal input impedance; and
   - control of the matching network to adjust the adjustable impedances to these new values.

3. Automatic impedance matching method according to one of Claims 1 and 2, **characterized in that** it includes the working out of an electrical control voltage, depending on a new adjustable impedance value for the matching network, and the application of this voltage to a variable capacitor which is controllable by an electrical voltage and forms part of the matching network.

4. Automatic impedance matching method according to one of Claims 1 to 3, **characterized in that** it includes the working out of switching control signals from the result of the calculation of a new value of the adjustable impedance and the application of these signals to a network of switchable elementary capacitors forming part of the matching network.

5. Radiofrequency transmission or reception system comprising at least an amplifier (PA) having a nominal load or input impedance, an antenna (ANT), and an impedance matching network (MN) between the amplifier and the antenna, this network comprising several impedances, some of which have adjustable numerical values, the system comprising:

    - a measurement capacitance ($C_a$) of known complex value inserted in series between the amplifier and the matching network;
    - means for measuring (MES) a first voltage, which is the voltage at the terminals of the measurement impedance, and a second voltage, which is the output voltage of the amplifier for a transmission system or the input voltage of the amplifier for a reception system;
    - means for calculating (CAL) the complex impedance defined by the relationship between the second voltage and the first voltage, taking account of the phase shift between these voltages, this complex impedance representing a present load or input impedance for the amplifier;
    - means for calculating (CAL) the antenna impedance as a function of this present load impedance and as a function of the known present values of the adjustable impedances of the matching network;
    - means for calculating, from a desired value of the load or input impedance of the amplifier and from the calculated value of the antenna impedance, new values for the adjustable impedances of the matching network, said new values allowing an overall load or input impedance of the amplifier to be obtained which is as close as possible to the nominal load or input impedance; and
    - means for electrically controlling (CTRL) the matching network to adjust the adjustable impedances to these new values.

6. Radiofrequency transmission or reception system according to claim 5, **characterized in that** the matching network comprises a T or Pi assembly of three reactive elements ($L, C_1, C_2$) .

7. Radiofrequency transmission or reception system according to Claim 6, **characterized in that** the T or Pi assembly comprises two capacitors ($C_1, C_2$) and one inductor (L) or two inductors and one capacitor.

8. Radiofrequency transmission or reception system according to Claim 7, **characterized in that** the matching network comprises two adjustable capacitors ($C_1, C_2$).

9. Radiofrequency transmission or reception system according to Claim 8, **characterized in that** the matching network comprises a n assembly with two adjustable capacitors ($C_1, C_2$) in parallel and an inductor (L) in series between the terminals of the two capacitors.

10. Radiofrequency transmission or reception system according to one of Claims 5 to 9, **characterized in that** the matching network comprises at least one variable capacitor consisting of a network of switchable elementary capacitors so as to establish at will capacitance values that are selectively adjustable by an electrical control.

11. Radiofrequency transmission or reception system according to one of Claims 5 to 9, **characterized in that** the matching network comprises at least one variable capacitor that can be controlled by an electric voltage.

FIG.1

Mesure  V et  va

Calcul Z   Zm = Za $\dfrac{V}{va}$

Calcul   Zant = f (Zm, Z1 , Z2, ... , Za)

Calcul  Z'1,Z'2 = f (Zant, Zopt)

Commande  MN

FIG.2

FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4375051 A

- US 6259334 B